# EUROPÄISCHE PATENTSCHRIFT

(11) **EP 2 092 806 B1**
(45) Veröffentlichungstag und Bekanntmachung des Hinweises auf die Patenterteilung: **11.09.2013**
(21) Anmeldenummer: 07846547.3
(22) Anmeldetag: 09.11.2007
(51) Int. Cl.: H05K 3/10, H05K 3/22, H05K 1/02, H05K 3/32, B23K 20/00, H01L 23/00, H05K 3/46

(54) **VERFAHREN ZUR HERSTELLUNG EINER LEITERPLATTE MIT ADDITIVEN UND INTEGRIERTEN UND MITTELS ULTRASCHALL KONTAKTIERTEN KUPFERELEMENTEN**
MANUFACTURING METHOD FOR CIRCUIT BOARD COMPRISING ADDITIONAL COPPER ELEMENTS THAT ARE INTEGRATED AND BROUGHT INTO CONTACT BY ULTRASOUND
PROCÉDÉ DE FABRICATION D'UNE CARTE À CIRCUIT IMPRIMÉ DOTÉE D'ÉLÉMENTS EN CUIVRE ADDITIONNELS INTÉGRÉS ET MIS EN CONTACT PAR ULTRASONS

(30) Priorität: 13.11.2006 DE 102006053697
(43) Veröffentlichungstag der Anmeldung: 26.08.2009
(73) Patentinhaber: Häusermann GmbH, 3571 Gars am Kamp (AT)
(72) Erfinder: OBERENDER, Lothar, 13467 Berlin (DE); JANESCH, Rudolf, 3571 Gars am Kamp (AT); STRUMMER, Erich, 3571 Gars am Kamp (AT); HACKL, Johann, 3571 Gars am Kamp (AT)
(74) Vertreter: Riebling, Peter
(86) Internationale Anmeldenummer: PCT/EP2007/009713
(87) Internationale Veröffentlichungsnummer: WO 2008/058673

(56) Entgegenhaltungen:
- DE-A1-102005 003 370
- US-A- 4 581 706
- US-A- 5 891 745
- US-A- 6 062 903
- US-B1- 6 372 999

## Beschreibung

Gegenstand der Erfindung ist ein Verfahren zur Herstellung einer Leiterplatte mit zumindest einer zusätzlichen elektrisch leitfähigen Struktur in Form eines runden oder rechteckigen elektrisch leitfähigen Verdrahtungselementes, insbesondere in Form eines länglichen Kupfer- beziehungsweise kupferhaltigen Elementes, das als additives Element mittels Ultraschall zumindest stückweise flächig auf Kupferfolienelemente mittels Ultraschall kontaktiert und derart in eine Leiterplatte integriert wird.

In der W002067642A1 beziehungsweise der DE10108168C1 wird ein Verfahren zur Herstellung einer Multiwire-Leiterplatte genannt, bei dem auf einer Seite eines dünnen Flächenelementes aus elektrisch leitendem Material mittels voneinander beabstandeter Klebeflächen Leitungsdrähte definiert verlegt und an vorgegebenen Kontaktstellen des Flächenelementes elektrisch mittels Schweißen, Bonden, Löten, Leitkleben o.dgl. kontaktiert werden.

Auf den fixierten Leitungsdrähten wird ein mechanisches Stabilisierungselement in Form eines Prepregs oder in Form eines mittels Isolierfolie aufgebrachten, elektrisch leitenden oder isolierenden Flächenelementes vorgesehen. Das Flächenelement wird dabei von der anderen Seite her derart strukturiert, dass die Kontaktstellen vom übrigen Flächenelement getrennt werden. Es werden Leitungsdrähte mittels Klebeflächen definiert verlegt.

Bei der genannten Druckschrift besteht der Nachteil, dass die an sich rund profilierten Leitungsdrähte mit Hilfe einer Verschweißung oder einer Bondverbindung elektrisch leitfähig mit den übrigen Teilen der Leiterplatte verbunden sind. Damit besteht jedoch der Nachteil, dass ein relativ dünner und runder Drahtquerschnitt auf einer großflächigen, metallisierten Kupferplatte nur punktweise kontaktiert werden kann.

Dies führt zu hohen Temperaturen an der Kontaktstelle und einer entsprechenden Wärmebelastung im Bereich der Leiterplatte, was zu Verwerfungen im Bereich der Kupferfolie und auch im Bereich der umliegenden Kunststoff-Materialien führt. Die Leiterplatte neigt deshalb zur Verwerfung an den genannten Kontaktstellen, und bei einer späteren fotolithografischen Bearbeitung der Platte ist eine ebene Oberfläche der Platte nicht mehr gegeben. Damit besteht der Nachteil, dass keine feinen Strukturen fehlerfrei auf die Oberfläche der Leiterplatte aufgebracht werden können. Damit wird die Ausschussquote sehr hoch.

In der W006077167A2 beziehungsweise der DE102005003370A1, wird ein Verfahren zur durchgehenden Verlegung wenigstens eines isolierten Leitungsdrahts zwischen auf einer Leiterplatte angeordneten elektrischen Anschlussstellen sowie eine Vorrichtung zur Ausführung des Verfahrens genannt.

Dabei wird ein Verfahren zum Verschweißen eines Leitungsdrahts mit einer leitfähigen Folie beschrieben, welches vorzugsweise zur Verbindung mit einem Leiterplattenträger zur Herstellung einer Leiterplatte bestimmt ist, wobei die Dicke oder der Durchmesser des Leitungsdrahtes vorzugsweise größer ist als die Dicke der leitfähigen Folie und wobei die leitfähige Folie sich zumindest während des Verschweißens mit einer thermischen Trennplatte in Kontakt befindet, deren Wärmeleitfähigkeit geringer ist als die der leitfähigen Folie.

Es wird also ein Verfahren und eine Vorrichtung auf Basis einer Widerstandsschweißung, jedoch nicht ein US-Schweißverfahren beschrieben, da nur bei einem elektrischen Widerstandsschweißverfahren eine thermische Trennplatte in Kontakt mit einer leitfähigen Folie benötigt wird.

Insbesondere kann eine Trennplatte bei einer Ultraschallverschweißung auf einer bereits geätzten Innenlage mit einer Epoxid-Glasgewebe Struktur auf der Rückseite keine gute thermische Ableitung bewirken, da eine derartige Struktur thermisch sehr schlecht leitet.

Mit der Druckschrift DE 10 2005 003 370 A1 wird ein Verfahren zur Herstellung einer Leiterplatte mit einer zusätzlichen elektrischen leitfähigen Struktur in Form eines runden elektrisch leitfähigen Verdrahtungselementes gezeigt. Das leitfähige Verdrahtungselement, welches als additives Element flächig auf Kupferfolienelemente kontaktiert wird, wird mittels eines Laminationsprozesses in die Leiterplatte integriert. Bei dem Verfahren findet jedoch sehr hohe Wärmebelastung bei dem Schweißprozess des Verdrahtungselementes statt.

Die Druckschrift US 5,891,745 zeigt ein Verfahren zur Befestigung eines Verdrahtungselementes auf einer Leiterplatte. Während des Prozess findet durch das Andrücken der Sontrode eine Querschnittverformung des Verdrahtungselementes statt. Hierbei wird das Verdrahtungselement einfach flach auf die Leiterplatte gedrückt. Dies bewirkt jedoch den wesentlichen Nachteil, dass die Stromleiteigenschaft im Bereich der Querschnittsverformung sehr beeinträchtigt wird.

Aufgabe der vorliegenden Erfindung ist die kostengünstige Herstellung von multifunktionellen Leiterplatten zur Verdrahtung von hochkomplexen Leiterstrukturen, insbesondere Fein- bis Feinstleiterstrukturen, gemeinsam mit Strukturen zur Leitung relativ hoher Ströme auf einer Platine.

Dieses Ziel wird durch ein Verfahren gemäß Anspruch 1.

Es wird weiters die Wärmeableitung durch die besondere Ausbildung derartiger zusätzlicher Elemente auf und/oder in einer Leiterplatte beschrieben und deren Anwendung für die Kontaktierung von Bauteilen zwecks Wärmeableitung.

In einer ersten Ausführungsvariante werden elektrisch leitfähige Verdrahtungselemente mittels Reibschweißverfahren oder Ultraschalischweißverfahren bevorzugt flächig auf eine darunter befindüchen ätztechnisch hergestellten Leiterstruktur befestigt und anschließend mittels entsprechender Harzsysteme einebnend bearbeitet.

In einer zweiten Ausführungsvariante werden elektrisch leitfähige Verdrahtungselemente mittels Reibschweißen beziehungsweise Ultraschall isolierend auf einem Leiterplattensubstrat befestigt. Dabei kann die Isolationsschicht vollflächig oder selektiv auf der entsprechenden Leiterplattenoberfläche angeordnet sein oder es kann das elektrisch leitfähige Verdrahtungselement auf der entsprechenden Seite oder umhüllend mit einem entsprechenden Harz versehen sein. Auf diese Weise wird eine eigenständige Verdrahtungsebene hergestellt. Die anschließende Einebnung mittels geeigneter Harzsysteme kann wie in der ersten Ausführungsvariante erfolgen.

In einer weiteren Ausbildung der vorliegenden Erfindung werden insbesondere flache Verdrahtungselemente als selektive wärmeableitende Elemente verwendet. Sie wirken dabei wie Kühlkörper. Dabei sind flächige Elemente in eine Innenlage oder auf einer der beiden Oberflächen positioniert und es wird im Anschluss an die Einebnung beziehungsweise Lamination eine Öffnung derart hergestellt, dass der jeweilige Bauteil in direktem wärmeleitendem Kontakt montiert werden kann.

Erfindungsgemäß wird dabei zumindest ein längliches Verdrahtungselement mittels einer speziell geformten Sonotrode im zumindest stückweise flächigen Kontaktbereich derart im Querschnitt verformt, dass die Kontaktfläche gegenüber der Folie um vorzugsweise 20% erhöht wird. Weitere bevorzugte Ausführungen sehen sogar eine Erhöhung der Kontaktfläche um mehr als 30% und ganz besonders um mehr als 50% gegenüber einer nicht verformten (linienförmigen) Kontaktfläche (eines Runddrahtes) vor.

In einer speziellen Ausführungsform wird das Verdrahtungselement im Querschnitt etwa dreiecksähnlich beziehungsweise trapezförmig verformt. Dadurch wird die gewünschte Vergrößerung der Kontaktfläche erreicht.

Mit der Verwendung von Verdrahtungselementen, deren Querschnitt von der Rundform abweicht ergeben sich wesentliche Vorteile:

Wie eingangs beschrieben, entstehen beim Verschweißen rundprofilierter Verdrahtungselementen auf einer ebenen Folie - bedingt durch die linienförmige Kontaktfläche - so starke Wärmebelastungen auf der ebenen Folie, dass diese beschädigt wird.

Hier setzt die Erfindung ein, die vorsieht, dass die Verdrahtungselemente mindestens an der Stelle ihrer Verschweißung auf der ebenen Folie an dieser Stelle abgeflacht werden und die Rundform an dieser Stelle verlieren.

Erfindungsgemäß werden dreiecksförmige, trapez- oder parallelogrammförmige Verformungen vorgesehen, mit dem Ziel, die stumpfe (und annährend abgeflachte) Seite des Verdrahtungselementes mit größerer Oberfläche auf der ebenen Folie aufzusetzen und dort zu verschweißen. Damit werden die Wärmeübergänge auf eine größere Fläche verteilt und es besteht keine Gefahr der Beschädigung der empfindlichen Folie. Sofern eine Widerstandsverschweißung angewendet wird, kann dann sogar die Schweißstromstärke erhöht werden, ohne dass die Gefahr besteht, dass die empfindliche CU-Folie beschädigt wird.

Zwar könnte man durchgehend Verdrahtungselemente verwenden, deren Querschnitt über die gesamte Länge von der Rundform abweicht, dies hat aber verschlechterte Stromleitungseigenschaften zur Folge. Aus diesem Grund sollen die Verdrahtungselemente mit einer daran angepassten Sonotrode nur am Ort ihrer Verschweißung auf der Kupferfolie eine abgeflachte Form erhalten.

In einer weiteren erfinderischen Ausbildung wird das längliche Verdrahtungselement in bestimmten Abständen flächig auf ein leitfähiges darunter befindliches Folienelement kontaktiert.

In einer weiteren speziellen Ausführung wird das längliche Verdrahtungselement abgewinkelt verlegt, wobei ganz besonders 45° Winkel als eine effiziente Lösung angegeben werden. Grundsätzlich kann jedoch auch eine Abwinkelung von 0° bis zu 180° realisiert werden.

In einer Weiterbildung der Erfindung wird jene Kupferfolienfläche, auf die ein längliches Verdrahtungselement mittels Ultraschall flächig thermisch und elektrisch gut leitend kontaktiert werden soll, vor der Ultraschallkontaktierung mittels einer flach ausgebildeten Sonotrode aus Titan derart behandelt, dass eine oxidfreie Oberfläche gegeben ist und derart eine gesicherte intermetallische Verbindung beim Ultraschallschweißvorgang erreicht wird.

Eine Sonotrode, die am Ort der Verschweißung eines Runddrahtes aus diesem eine abgeflachte Form gestaltet, hat zum Beispiel einen dreiecksförmigen Querschnitt mit einer Länge von etwa 2 - 3 mm. Die Tiefe der V-förmigen Ausnehmung in der Sonotrode muss jedoch kleiner sein als der darin aufgenommene Querschnitt des dreiecksförmig verformten Drahtes. Ein solcher Runddraht hat beispielsweise einen Durchmesser von 500µm. Damit wird vermieden, dass die Sonotrode selbst auf der CU-Folie aufliegt, was diese andernfalls beschädigen würde.

Die Sonotrode muss eine großflächige Anlage auf der CU-Oberfläche des zu verformenden Drahtes gewährleiten, ansonsten die Reibschweißenergie nicht ausreichend übertragen werden könnte. Durch den Druck der Sonotrode auf den runden Querschnitt des Kupferleiters (Verdrahtungselement) und durch die US-Energie wird der Querschnitt abgeflacht und mit seiner abgeflachten Breitseite auf die Oberfläche der CU-Folie aufgepresst und dort durch Reibschweißung stoffschlüssig angeschweißt. Damit wird eine wesentlich größere Auflagefläche in der Ankoppelung an die darunter liegende CU-Folie erreicht.

Diese CU-Folie hat dabei eine Dicke von lediglich 9 oder 17oder 35 µm. Diese Angaben beziehen sich auf standardisierte Dicken üblich verwendeter CU-Folien.

Selbstverständlich bezieht sich die Verformung eines Runddrahtes in ein dreiecksförmiges Profil am Ort seiner Verschweißung auf der CU-Folie nur auf eine bevorzugte Ausführung der Erfindung. Die Erfindung umfasst jedoch andere abgeflachten Profilformen von derartigen Runddrähten. Insbesondere auch trapez- und parallelogrammartige Profilformen.

Alle in den Unterlagen, einschließlich der Zusammenfassung offenbarten Angaben und Merkmale, insbesondere die in den Zeichnungen dargestellte Ausbildung, werden als erfindungswesentlich beansprucht, soweit sie einzeln oder in Kombination gegenüber dem Stand der Technik neu sind.

Die Erfindung wird nun anhand mehrerer Ausführungsbeispiele näher beschrieben. Hierbei gehen aus den Zeichnungen und ihrer Beschreibung weitere Vorteile und Merkmale hervor.

Einige Ausführungsbeispiele der Erfindung werden nachfolgend anhand der Zeichnungsfiguren näher beschrieben.

Dabei zeigen:
**Figur 1****:** eine Draufsicht auf ein Verdrahtungsschema A (15), **Figur 2****:** einen Querschnitt durch eine multifunktionelle Leiterplatte (1) im Bereich eines 500 µm dicken Kupferrunddrahtes (3) im Schnitt A-B der Figur 1 im nicht kontaktierten Bereich,
**Figur 3****:** eine Draufsicht auf ein Verdrahtungsschema B (16),
**Figur 4****:** einen Querschnitt durch eine multifunktionelle Leiterplatte (1) im Bereich eines 500 µm dicken Kupferrunddrahtes (3) im Schnitt A-B der Figur 3 im kontaktierten Bereich (6) inklusive einer trapezförmigen Verformung des runden Drahtelementes (3),
**Figur 5****:** eine Draufsicht auf die Unterseite einer 70µm Kupferfolie mit stückweise ultraschallverschweißten (6) 500 µm Kupferdrähten (3),
**Figur 6****:** einen Schliff im Bereich der Ultraschallkontaktierung (6) eines ursprünglich 500 µm dicken Kupferrunddrahtes (3) auf einer 70 µm dicken Kupferfolie (4),
**Figur 7****:** einen Schliff im Bereich der Ultraschallkontaktierung (6) eines ursprünglich 500 µm dicken Kupferrunddrahtes (3) auf einer 35 µm dicken Kupferfolie (4),
**Figur 8****:** einen Schliff im Bereich der Ultraschallkontaktierung (6) eines 500 µm dicken Kupferbandelementes (3) auf einer 35 µm dicken Kupferfolie (4),
**Figur 9****:** einen Schliff im Bereich der Ultraschallkontaktierung (6) eines ursprünglich 500 µm dicken Kupferrunddrahtes (3) auf einer 35 µm dicken Kupferfolie (4) mit einer ausgeprägten Dreiecksform,
**Figur 10****:** einen Schliff im Bereich der Ultraschallkontaktierung (6) eines ursprünglich 500 µm dicken Kupferrunddrahtes (3) auf einer 35 µm dicken Kupferfolie (4) eingebettet in einer FR-4 Harzmasse,
**Figur 11****:** einen Schliff im Bereich der Ultraschallkontaktierung (6) eines ursprünglich 500 µm dicken Kupferrunddrahtes (3) auf einer 70 µm dicken Kupferfolie (4) eingebettet in einer FR-4 Harzmasse.
**In** **Figur 12** wird schematisch ein Schnitt durch ein Substrat (2) mit einer Leiterbahn (4) mit einem runden Draht (3) und einer darüber angeordneten Sonotrode (18) vor der Kontaktierung dargestellt
**In** **Figur 13** wird schematisch ein Schnitt durch ein Substrat (2) mit einer Leiterbahn (4) mit einem runden Draht (3) und einer darüber angeordneten Sonotrode (18) nach der Kontaktierung dargestellt

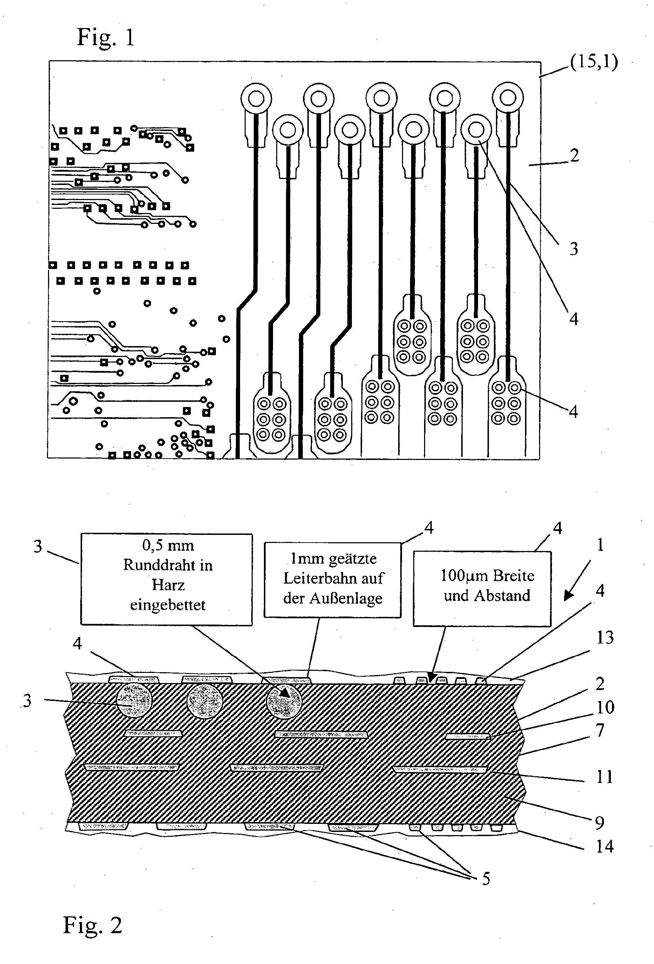

In **Figur 1** wird eine Draufsicht auf ein Verdrahtungsschema A (15) beziehungsweise auf eine schematisch dargestellte multifunktionelle Leiterplatte (1) gezeigt. Im linken Bereich dieser Draufsicht sind übliche Details einer Feinstrukturverdrahtung schematisch zu erkennen. Im rechten Bereich sind 9 Verdrahtungselemente (3) schematisch dargestellt, die zumindest an den Anfangs- und Endstellen mittels flächiger Ultraschallkontakte auf einer darunter befindlichen Kupferfolie (4) angeordnet sind.

Beim Ultraschallkontaktierungsvorgang kann die Kupferfolie (4) vollflächig oder bereits strukturiert ausgeführt sein. Bei Verwendung einer vollflächigen Kupferfolie (4) kann diese als Kupferfolie ohne und mit Harzschicht (2), beispielsweise einer Epoxidharz-Glasgewebe-Schicht, versehen sein. Eine strukturierte Kupferfolie (4) wird üblicherweise als Innenlage beziehungsweise Kernlage oder als Außenlage mittels Ätztechnik hergestellt. In dieser Figur 1 sind als funktionelle Elemente (3) Runddrähte mit 500 µm Durchmesser aus Kupfer eingezeichnet.

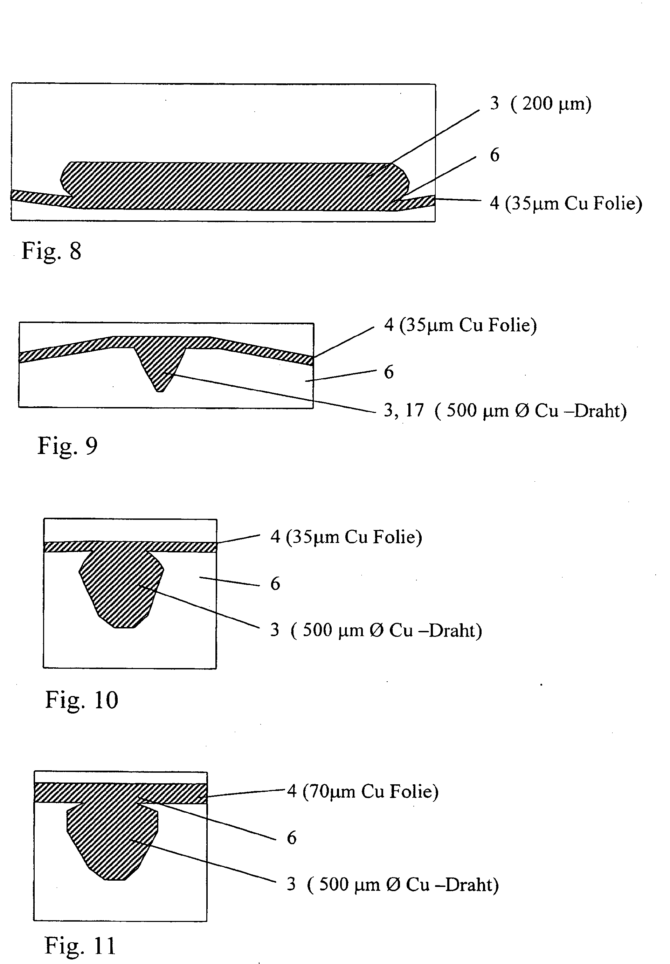

Im Vergleich zu einer 35 µm dicken Kupferstruktur kann ein 500 µm dicker Kupferdraht eine beträchtlich höhere Stromdichte ohne wesentliche Erwärmung realisieren. Grundsätzlich kann das Element (3) mit einem Durchmesser von minimal etwa 30 µm bis zu den genannten 500 µm und für Spezialanwendungen auch grundsätzlich darüber ausgeführt werden. Alternativ zu der Ausführung des Elementes (3) als Runddraht kann dieser auch als Flachprofil (siehe Figur 8) ausgeführt werden, beispielsweise mit für übliche Leiterplattenaufbauten verträglicher Stärke bis zu etwa 500 µm Dicke und mehreren Millimetern Breite, typisch 2 bis 6 mm Breite und in Spezialfällen können auch Querschnitte verwendet werden, die darüber liegen.

In allen Fällen muss die Drahtzuführung derartiger Elemente (3) inklusive der Sonotrode und des Niederhalters, des Einkerb- beziehungsweise Einschneidewerkzeuges und des Abreißklemmwerkzeuges auf den verwendeten Querschnitt des Elementes (3) ausgelegt werden. Weiters ist erkenntlich, dass mit Runddrahtelementen (3) eine abgewinkelte Verlegung einfacher auszuführen ist als mit rechteckförmigen Querschnitten.

In **Figur 2** wird ein Querschnitt durch eine multifunktionelle Leiterplatte (1) im Bereich eines 500 µm dicken Kupferrunddrahtes (3) im Schnitt A-B der Figur 1 im nicht kontaktierten Bereich aufgezeigt. Diese multifunktionelle Leiterplatte (1) weist demgemäß zwei außen liegende Leiterplattenstrukturen (4, 5) mit den isolierenden Lötstoppmasken (13, 14) auf und zwei innen liegende Leiterbahnstrukturen (10, 11). Die Bereiche (2, 7, 9) zwischen den leitfähigen Strukturen sind bei einem typischen FR-4 Leiterplattenaufbau aus Epoxidharz-Glasgewebe, können jedoch grundsätzlich auch aus einem üblichen Prepreg Material, aus FR-2, FR-3, FR-4-Low-Tg, CEM-1, CEM-x, PI, CE, Aramid und weiteren Materialien nach dem Stand der Technik in der Leiterplattenindustrie bestehen.

Die drei in Figur 2 gezeichneten Runddrahtelemente (3) sind gemäß dem Schnitt A-B in Figur 1 schematisch dargestellt. Die Runddrahtelemente (3) sind dabei in dem Bereich dargestellt, in dem sie nicht mittels Ultraschall auf einer Leiterbahn (4) kontaktiert sind; sie sind demgemäß mit rundem Querschnitt dargestellt. In dieser Figur 2 wird ein Linienkontakt zwischen Runddraht (3) und Leiterbahn (4) gezeigt.

Eine derartige Kontaktausbildung entsteht erfahrungsgemäß nur dann, wenn der Abstand der einzelnen Ultraschallkontaktierungen nahe genug bezogen auf den Drahtdurchmesser (3) erfolgt. Bei allen realisierten Abständen kann Harz zwischen das Runddrahtelement (3) und die Leiterbahn (4) treten, was grundsätzlich gewollt und notwendig ist. Dies führt zu keiner elektrischen bzw. thermischen Kopplung. Es werden entsprechend dem Drahtquerschnitt (3) und dem vorgegebenen Layout bestimmte Mindestabstände zwischen flächigen Ultraschallkontakten vorgesehen.

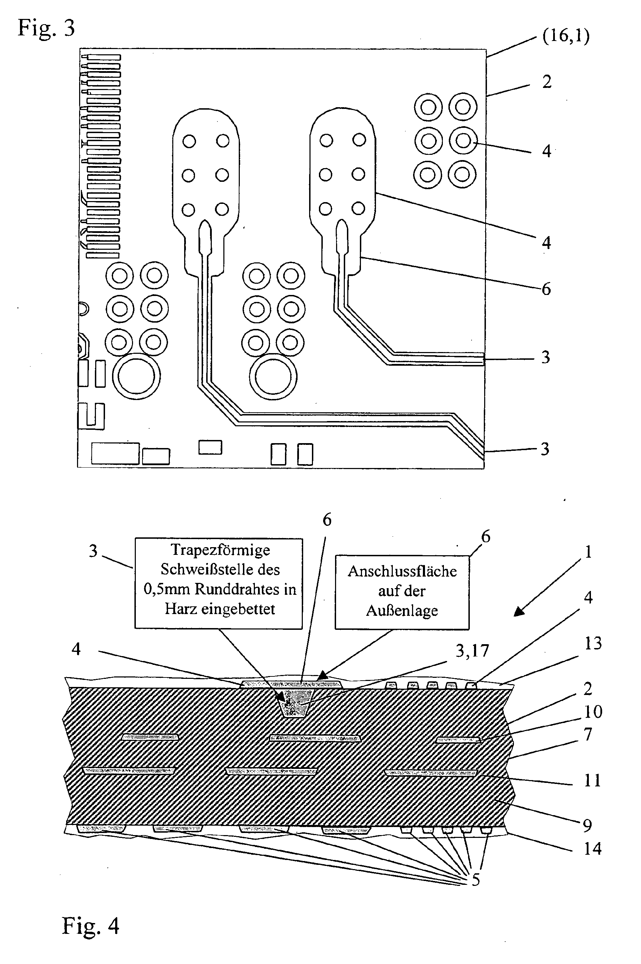

In **Figur 3** wird eine Draufsicht auf ein Verdrahtungsschema B (16) beziehungsweise auf eine schematisch dargestellte multifunktionelle Leiterplatte (1) mit einem Substrat (2) und mit Leiterbahnstrukturen (4) und funktionalen Elementen (3) in Form von beispielhaft einem 500 µm Kupferrunddraht aufgezeigt. Diese Elemente (3) werden in vorgegebenen Bereichen (6) der Leiterbahnstruktur (4) mittels Ultraschall flächig kontaktiert.

In **Figur 4** wird ein Querschnitt durch eine multifunktionelle Leiterplatte (1) im Bereich eines 500 µm dicken Kupferrunddrahtes (3) im Schnitt A-B der Figur 3 und derart im kontaktierten Bereich (6) inklusive einer trapezförmigen Verformung 17 des runden Drahtelementes (3) aufgezeigt. In dieser schematischen Darstellung, die auf einem Schliffbild beruht, wurde der runde Kupferdraht (3) mittels einer speziell gestalteten Sonotrode in diese trapezartige Form gebracht. Diese kantige trapezartige Form ist zwar herstellbar, wird aber in der Praxis durch eine abgerundete Form ausgeführt und wird speziell im Kontaktbereich reduziert und vorsichtig ausgeführt, da ein Abdruck der Sonotrode auf der Oberfläche der Leiterbahn (4) kontraproduktiv wäre.

Als intermetallische Fläche (6) wird in dieser Abbildung der Kontaktbereich zwischen dem Drahtelement (3) und der Leiterbahnoberfläche (4) ausgebildet und es ist gezeigt, dass dieser Bereich weitgehend eben ausgebildet ist und keine Verwerfungen aufweist, wie dies bei einem punktuellen Widerstandsschweißvorgang nach dem Stand der Technik entstehen würde.

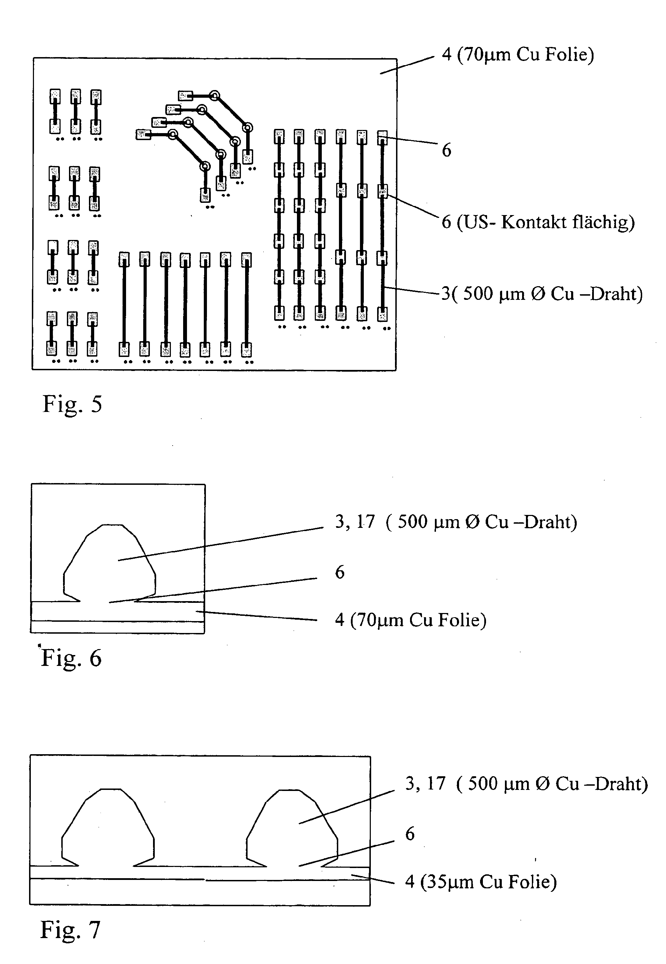

In **Figur 5** wird eine Draufsicht auf die Unterseite einer 70µm Kupferfolie (4) mit stückweise US-verschweißten (6) 500 µm Kupferdrähten (3) aufgezeigt. Diese Kupferfolie beziehungsweise dieses Testlayout wurde mit einer Vielzahl von Varianten ausgeführt. Diese Aufnahme zeigt die Kontaktierung von 500 µm dickem Kupferrunddraht auf einer 70 µm dicken Kupferfolie (4) auf, die nicht strukturiert ist und die keinen Harzträger aufweist. Eine derartige Kupferfolie (4) wird nach der Applikation der Drahtelemente (3) einem Laminationsvorgang unterzogen und ätztechnisch an der den Drahtelementen (3) gegenüberliegenden Seite strukturiert beziehungsweise werden die Drahtelemente (3) beim Laminiervorgang in einer Leiterplattenpresse nach dem Stand der Technik in der Harzlage eingebettet. Dabei kann es hilfreich sein, dass die Laminierparameter, also der Verlauf der Druckbeaufschlagung und der Verlauf der Temperaturerhöhung und des Kühlvorganges in einer Heiz-Kühl-Transferpresse spezifisch auf diesen Einbettungsvorgang abgestimmt wird. Bei entsprechend großen Drahtquerschnitten (3) wird speziell der Aufwärmvorgang und die Druckerhöhung derart abgestimmt werden, dass eine gute Einbettung stattfindet. Eine entsprechende Vakuumunterstützung kann zusätzlich den Einschluss von Luftbläschen vermeiden. Der Abkühlvorgang muß entsprechend der höheren Kupfermasse im Allgemeinen länger ausgeführt werden.

In Figur 5 sind einzelne Runddrahtelemente (3) mittels Ultraschall in unterschiedlichen Abständen auf die Kupferfolie (4) kontaktiert. Diese Versuche pro Drahtquerschnitt dienen zur Optimierung der Sonotrode beziehungsweise der Niederhalter der Drahtelemente (3) für eine möglichst plane Verlegung, das heißt, dass die Drahtelemente (3) zwischen den einzelnen flächigen Ultraschallkontaktstellen (6) möglicht im Linienkontakt auf der Kupferoberfläche (4) angeordnet werden.

Weiters wird in Figur 5 die gewinkelte Verlegung aufgezeigt. Dabei wird der Sonotrodenkopf inklusive der Drahtzuführung um beispielsweise 45° gedreht oder aber der Tisch mit der Kupferfolie (4) wird gedreht. Gleichzeitig muss der Draht (3) gebogen werden. Er muss also beim Ultraschallschweißvorgang mechanisch so lange niedergehalten werden, bis der Biegevorgang beendet ist. Ein Ultraschallweißvorgang ist zwar ein weitgehend kalter Schweißvorgang, allerdings wird im Bereich der Bildung der intermetallischen Verbindung eine relativ hohe Temperatur bis in den Bereich des Schmelzpunktes von Kupfer bei 1.083°C erreicht. Da üblicherweise eine Sonotrode eine relativ große Masse im Vergleich zu den Drahtelementen (3) aufweist, kann die Verweildauer der Sonotrode nach dem Ultraschallschweißvorgang die Ableitung der erzeugten Wärme bewirken und kann überdies eine mechanische Verfestigung durch die Druckbeaufschlagung bewirken. Die US-Sonotrode kann überdies mit einer aktiven Kühlung versehen werden.

In **Figur 6** wird ein Schliff im Bereich der Ultraschallkontaktierung (6) eines ursprünglich 500 µm dicken Kupferrunddrahtes (3) auf einer 70 µm dicken Kupferfolie (4) aufgezeigt. Bei diesem Schliff wurde die Kupferfolie (4) mit dem Drahtelement (3) im Bereich der Ultraschallschweißung (6) in ein Gießharz eingebettet und dann in diesem Bereich gesägt und geschliffen. Die dreieckförmige Ausbildung (Verformung 17) des ursprünglichen Runddrahtes (3) ist sehr typisch für einen optimal eingestellten Prozess, da in diesem Fall die Sonotrode noch genügend Abstand zur Kupferoberfläche (4) aufweist und die intermetallische Verbindungsfläche (6) ausreichend groß ist.

In **Figur 7** wird ein Schliff im Bereich der Ultraschallkontaktierung (6) eines ursprünglich 500 µm dicken Kupferrunddrahtes (3) auf einer 35 µm dicken Kupferfolie (4) aufgezeigt. Der Winkel der dreiecksförmigen Verformung wurde auch hier in Form eines gleichwinkligen Dreiecks gewählt. Der intermetallische Kontaktbereich (6) wurde mit 430 µm ermittelt und die maximale Breite des Dreiecks wurde mit 490 µm ermittelt.

In **Figur 8** wird ein Schliff im Bereich der Ultraschallkontaktierung (6) eines 500 µm dicken Kupferbandelementes (3) auf einer 35 µm dicken Kupferfolie (4) aufgezeigt. Das Kupferbandelement (3) weist im unverformten Zustand eine Breite von etwa 3,75 mm auf. Durch den Ultraschallkontaktierprozess bei typisch 30 bis 60 kHz und einer entsprechenden Druckkraftbeaufschlagung wurde eine Breitenvergrößerung auf 4,04 mm bewirkt. Der intermetallische Kontaktbereich (6) wurde mit 3,77 mm ermittelt, was nahezu mit der Originalbreite des Kupferbandes (3) übereinstimmt.

In **Figur 9** wird ein Schliff im Bereich der Ultraschallkontaktierung (6) eines ursprünglich 500 µm dicken Kupferrunddrahtes (3) auf einer 35 µm dicken Kupferfolie (4) mit einer ausgeprägten gleichwinkligen Dreiecksform aufgezeigt. Dieses Muster wurde vor dem Laminationsvorgang, also ohne Einbettung in eine Leiterplattenstruktur, mit einem für Schliffe geeigneten Harz ausgegossen, gesägt und geschliffen. Die schöne gleichwinklige Dreiecksform bleibt auch beim Laminiervorgang erhalten, erfordert jedoch prozesstechnisch exakte Bedingungen.

In **Figur 10** wird ein Schliff im Bereich der Ultraschallkontaktierung (6) eines ursprünglich 500 µm dicken Kupferrunddrahtes (3) auf einer 35 µm dicken Kupferfolie (4) eingebettet in einer FR-4 Harzmasse aufgezeigt. Hier wurde ein Teil einer multifunktionellen Leiterplatte im Bereich der Ultraschallkontaktstelle gesägt und geschliffen. Durch diese Art der Sonotrodenausbildung und der damit verbundenen Verformung und der anschließenden Lamination zu einer Leiterplatte erfolgt eine lufteinschlussfreie Einbettung des Drahtelementes (3) mit einem sehr großen intermetallischen flächigen Kontaktbereich (6) auf der Oberfläche einer Leiterbahn (4).

In **Figur 11** wird ein Schliff im Bereich der Ultraschallkontaktierung (6) eines ursprünglich 500 µm dicken Kupferrunddrahtes (3) auf einer 70 µm dicken Kupferfolie (4) eingebettet in einer FR-4 Harzmasse aufgezeigt. Hier gelten die Anmerkungen wie in Figur 4 und wurde statt einer 35 µm dicken Leiterbahn (4) eine 70 µm dicke Leiterbahn verwendet.

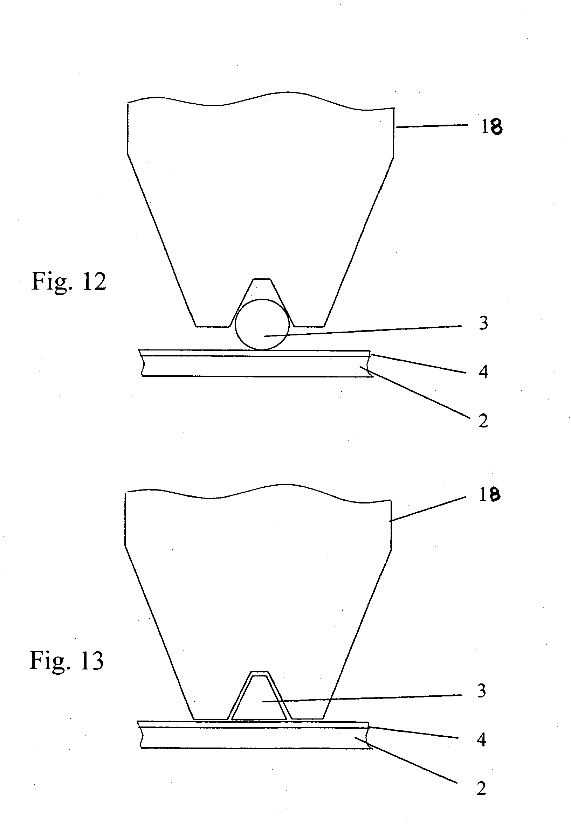

In **Figur 12** wird schematisch ein Schnitt durch ein Substrat (2) mit einer Leiterbahn (4) mit einem runden Draht (3) und einer darüber angeordneten Sonotrode (18) vor der Kontaktierung dargestellt. In dieser Darstellung berührt die Sonotrode (17) den Draht (3) nur punktuell, also gerade in dem Moment, ab dem eine Verformung durch den Druck beginnt. Der Draht (3) berührt ebenfalls nur punktuell die Oberfläche der Leiterbahn (4).

In **Figur 13** wird schematisch ein Schnitt durch ein Substrat (2) mit einer Leiterbahn (4) mit einem runden Draht (3) und einer darüber angeordneten Sonotrode (18) nach der Kontaktierung dargestellt. In dieser Darstellung hat die Sonotrode (18) den Draht (3) bereits dreiecksartig geformt und der Draht (3) ist flächig mit der Oberfläche der Leiterbahn (4) durch eine intermetallische Verbindung (6) mittels Ultraschall thermisch und elektrisch gut leitfähig verbunden.

### Bezugszeichenliste

- 1: Multifunktionelle Leiterplatte mit zumindest einem funktionalen Element
- 2: Substrat (Harzschicht): Basismaterial z.B. FR-2, FR-3, FR-4, FR-4-Low-Tg, CEM-1, CEM-x, PI, CE, Aramid, usw. bzw. Prepreg
- 3: Funktionales Element: rund oder rechteckig bzw. bandförmig; Kupfer oder Aluminium oder elektrisch u/o thermisch gut leitfähig
- 4: Leiterbahnstruktur: z.B. geätztes Kupfer
- 5: Leiterbahnstruktur Unterseite
- 6: Intermetallische Verbindung: US- bzw. Reibschweißen
- 7: Substrat 2: z.B. Innenlage bzw. Kernlage
- 8: Substrat 3: z.B. Innenlage bzw. Kernlage
- 9: Substrat 4: z.B. Außenlage bzw. Prepreg
- 10: Leiterbahnstruktur innenliegend
- 11: Leiterbahnstruktur innenliegend
- 12: Leiterbahnstruktur außenliegend
- 13: Soldermaske bzw. Lötstopmaske oben
- 14: Soldermaske bzw. Lötstopmaske unten
- 15: Verdrahtungsschema A bzw. Layout A
- 16: Verdrahtungsschema B bzw. Layout B
- 17: Verformung
- 18: Sonotrode

## Patentansprüche

1. Verfahren zur Herstellung einer Leiterplatte (1) mit zumindest einer zusätzlichen elektrisch leitfähigen Struktur in Form eines runden oder rechteckigen elektrisch leitfähigen Verdrahtungselementes (3), das als additives Element flächig auf Kupferfolienelemente (4) kontaktiert wird und mittels eines Laminationsprozesses in die Leiterplatte (1) integriert wird, **dadurch gekennzeichnet, dass** das zumindest eine längliche Verdrahtungselement (3) mittels einer Sonotrode, die eine Ausnehmung mit einem dreiecksähnlichen beziehungsweise trapezförmigen Querschnitt aufweist, im zumindest stückweisen flächigen Kontaktbereich (6) derart im Querschnitt verformt wird, dass die Kontaktfläche (6) in Richtung auf die Leiterbahnstruktur (4) größer als im unverformten Zustand ist.

2. Verfahren zur Herstellung einer Leiterplatte (1) nach Anspruch 1, **dadurch gekennzeichnet, dass** dabei das Verdrahtungselement (3) im zumindest stückweisen flächigen Kontaktbereich (6) derart im Querschnitt verformt wird, dass die Kontaktfläche (6) zumindest um 20%, insbesondere um mehr als 30% und ganz besonders um mehr als 50% gegenüber einer nicht verformten Kontaktfläche größer ist.

3. Verfahren zur Herstellung einer Leiterplatte (1) nach Anspruch 1 oder 2, **dadurch gekennzeichnet, dass** dabei das Verdrahtungselement (3) im Querschnitt etwa dreiecksähnlich beziehungsweise trapezförmig verformt wird und derart ein Erhöhung der Kontaktfläche (6) erreicht wird.

4. Verfahren zur Herstellung einer Leiterplatte (1) nach einem der Ansprüche 1 bis 3, **dadurch gekennzeichnet, dass** dabei das längliche Verdrahtungselement (3) in bestimmten Abständen stückweise flächig auf ein leitfähiges darunter befindliches Folienelement (4) kontaktiert wird.

5. Verfahren zur Herstellung einer Leiterplatte (1) nach einem der Ansprüche 1 bis 4, **dadurch gekennzeichnet, dass** dabei das längliche Verdrahtungselement (3) abgewinkelt verlegt wird, wobei ganz besonders eine 45° Abwinkelung bis zu 90° und bis zu 180° realisiert wird.

6. Verfahren zur Herstellung einer Leiterplatte (1) nach einem der Ansprüche 1 bis 5, **dadurch gekennzeichnet, dass** dabei jene Kupferfolienfläche (4), auf die ein längliches Verdrahtungselement (3) mittels Ultraschall flächig thermisch und elektrisch leitend kontaktiert werden soll, vor der Ultraschallkontaktierung mittels einer flach ausgebildeten Sonotrode (18) aus Titan derart behandelt wird, dass eine oxidfreie Oberfläche entsteht und derart eine intermetallische Verbindung beim Ultraschallschweißvorgang erreicht wird.

## Claims

1. Method for producing a circuit board (1) with at least one additional electrically conductive structure in the form of a round or rectangular electrically conductive wiring element (3), which, as an additive element, is brought into plane contact with copper foil elements (4) and is integrated into the circuit board (1) by means of a lamination process, **characterised in that** the at least one elongate wiring element (3) is deformed in cross-section by means of a sonotrode, which has a recess with a triangle-like or trapezoidal cross-section in the contact region (6) that is plane, at least in parts, in such a way that the contact face (6) is larger in the direction of the conductor path structure (4) than in the non-deformed state.

2. Method for producing a circuit board (1) according to claim 1, **characterised in that** the wiring element (3) is deformed in cross-section in the process in the contact region (6) that is plane, at least in parts, in such a way that the contact face (6) is larger by at least 20%, in particular by more than 30% and quite particularly by more than 50% compared to a non-deformed contact face.

3. Method for producing a circuit board (1) according to claim 1 or 2, **characterised in that** the wiring element (3) is deformed in cross-section approximately in a triangle-like or trapezoidal manner in the process and an increase in the contact face (6) is thereby achieved.

4. Method for producing a circuit board (1) according to any one of claims 1 to 3, **characterised in that** the elongate wiring element (3) is brought into plane contact in parts in the process at specific intervals with a conductive foil element (4) located therebelow.

5. Method for producing a circuit board (1) according to any one of claims 1 to 4, **characterised in that** the elongate wiring element (3) is in the process laid at an angle, a 45° angling up to 90° and up to 180° being quite particularly realised.

6. Method for producing a circuit board (1) according to any one of claims 1 to 5, **characterised in that** that copper foil face (4), with which an elongate wiring element (3) is to be brought into plane contact by means of ultrasound in a thermally and electrically conductive manner, is treated before the ultrasound contact by means of a flat sonotrode (18) made of titanium in such a way that an oxide-free surface is produced and an intermetallic connection is thus achieved during the ultrasonic welding process.

## Revendications

1. Procédé pour fabriquer une carte à circuit imprimé (1) avec au moins une structure supplémentaire conductrice d'électricité, sous la forme d'un élément de câblage conducteur d'électricité (3) rond ou rectangulaire qui est monté à plat, comme élément supplémentaire, sur des éléments en feuille de cuivre (4) et qui est intégré dans la carte imprimée (1) à l'aide d'un procédé de stratification, **caractérisé en ce que** ledit élément de câblage oblong (3) est déformé en section transversale à l'aide d'une sonotrode qui présente un creux à section transversale quasi triangulaire, ou trapézoïdale, dans la zone de contact (6) au moins par endroits plane, de telle sorte que la surface de contact (6), en direction de la structure de pistes conductrices (4), soit plus grande qu'à l'état non déformé.

2. Procédé pour fabriquer une carte à circuit imprimé (1) selon la revendication 1, **caractérisé en ce que** l'élément de câblage (3) est déformé en section transversale, dans la zone de contact (6) au moins par endroits plane, de telle sorte que la surface de contact (6) soit plus grande d'au moins 20 %, en particulier de plus de 30 % et plus spécialement de plus de 50 %, par rapport à une surface de contact non déformée.

3. Procédé pour fabriquer une carte à circuit imprimé (1) selon la revendication 1 ou 2, **caractérisé en ce que** l'élément de câblage (3) est déformé en section transversale selon une forme quasi triangulaire, ou trapézoïdale, et de telle sorte qu'on obtienne un accroissement de la surface de contact (6).

4. Procédé pour fabriquer une carte à circuit imprimé (1) selon l'une des revendications 1 à 3, **caractérisé en ce que** l'élément de câblage oblong (3) est monté suivant des intervalles définis, à plat par endroits, sur un élément en feuille conducteur (4) situé au-dessous,.

5. Procédé pour fabriquer une carte à circuit imprimé (1) selon l'une des revendications 1 à 4, **caractérisé en ce que** l'élément de câblage oblong (3) est posé en formant un coude, un coude de 45° à 90° et à 180° étant tout particulièrement réalisé.

6. Procédé pour fabriquer une carte à circuit imprimé (1) selon l'une des revendications 1 à 5, **caractérisé en ce que** la surface de feuille de cuivre (4) sur laquelle un élément de câblage oblong (3) doit être monté à plat à l'aide d'ultrasons, de manière conductrice de chaleur et d'électricité, est traitée, avant le montage à ultrasons, à l'aide d'une sonotrode (18) de forme plate en titane, de telle sorte qu'il se forme une surface sans oxyde et qu'on obtienne ainsi une liaison intermétallique lors de l'opération de soudage aux ultrasons.
